(19) Europäisches Patentamt
European Patent Office
Office européen des brevets

(11) **EP 1 580 528 A1**

(12) **EUROPEAN PATENT APPLICATION**

(43) Date of publication:
28.09.2005 Bulletin 2005/39

(51) Int Cl.7: **G01C 19/16**, F16C 33/10, B81B 5/00

(21) Application number: 05251555.8

(22) Date of filing: 15.03.2005

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: 26.03.2004 US 810774

(71) Applicant: LUCENT TECHNOLOGIES INC.
Murray Hill, New Jersey 07974-0636 (US)

(72) Inventors:
• **Kroupenkine, Timofei N.**
Warren NJ 07059 (US)

• **Taylor, Joseph A.**
Springfield NJ 07081 (US)
• **Weiss, Donald**
Cresskill NJ 07626 (US)

(74) Representative:
**Watts, Christopher Malcolm Kelway et al**
**Lucent Technologies NS UK Ltd**
**5 Mornington Road**
**Woodford Green**
**Essex, IG8 0TU (GB)**

(54) **Nanostructured liquid bearing**

(57) A liquid bearing is disclosed wherein a droplet of liquid separates a first surface having a plurality of nanostructures from a second surface which may or may not be nanostructured. In one embodiment, the liquid droplet is in contact with the nanostructures on the first surface and the second surface in a way such that friction is reduced between the first and second surfaces as one or both surfaces move laterally or rotationally. In one illustrative embodiment, the first surface of the bearing is a surface of a housing in a gyroscope and the second surface is a nanostructured surface of a mass adapted to rotate within the housing. Thus situated, the rotating mass moves with very low friction thereby permitting, for example, the manufacture of very small, highly precise gyroscopes.

*FIG. 4*

# Description

## Field of the Invention

The present invention relates generally to bearings and, more particularly, to liquid bearings having nanostructured surfaces.

## Background of the Invention

Bearings are extremely well-known as being advantageous in many varied applications to reduce friction between two surfaces and to carry loads for rotary or linear motion. Some bearings in some applications, such as ball bearings, roller bearings, plain bearings and sleeve bearings, rely on mechanical components (such as metal or ceramic balls in the case of some ball bearings) to reduce friction and support a load. Other bearings, such as air bearings and liquid bearings use a volume of air or liquid, respectively, to reduce friction between surfaces and to support loads. In such liquid or air bearings, a layer of fluid (e.g., a liquid or a gas) is injected between the surfaces to create an interface between those surfaces that has substantially reduced friction when compared to the friction between contacting solid surfaces without the benefit of the fluid intermediate layer.

One of the many varied uses of bearings is in devices such as gyroscopes. Traditional gyroscopes, which are well known in the art, are typically devices consisting of a spinning mass, such as a disk or wheel, mounted on a base or in a housing so that an axis of the disk or wheel can turn freely in one or more directions and thereby maintain its orientation regardless of any movement of the base or housing. Bearings are frequently used in such gyroscopes to reduce friction between the disk/wheel and the base or housing as the disk/wheel spins.

However, the use of traditional gyroscope components does not scale well to smaller devices using traditional bearings. Specifically, when the device using the bearing becomes very small, ever smaller bearings are required. However, the smaller the bearing, the less effective it is at reducing friction in such small devices. Additionally, a small spinning mass such as is used in a traditional gyroscopes leads to a correspondingly reduced angular momentum of the mass. Specifically, a gyroscope operates on the principle of preservation of angular momentum. This principle teaches that a rotating mass will retain its direction and magnitude of angular momentum in the absence of an external torque large enough in magnitude to overcome this angular momentum. Angular momentum (L) is defined by the equation:

$$L = 1 * w \qquad \text{Equation 1}$$

where I is the moment of inertia and w is the angular velocity. The moment of inertia is defined by the equation

$$I = \tfrac{1}{2} MR^2 \qquad \text{Equation 2}$$

where M is the mass of the disk and R is the radius of the disk. Thus, for extremely small mass and radius disks, the moment of inertia is correspondingly small. Therefore, at traditional rotational velocities, the angular momentum of such a small disk will be low enough that it will typically be easily overcome by a small applied torque that will disturb the operation of the gyroscope. While one method of increasing the angular momentum would be to increase the angular velocity of the mass, the friction resulting from prior bearings would limit the maximum increase in velocity. Hence, prior rotational gyroscopes having such small dimensions are limited in their usefulness.

More recently, in order to address the need for small gyroscopes, microelectronic mechanical systems (MEMS) gyroscopes have been developed and manufactured. Such gyroscopes are manufactured using well known substrate processing techniques, such as lithography and etching, and typically do not rely on a spinning mass. Instead, MEMS gyroscopes typically consist of a small oscillating mass that is anchored to a substrate by flexible tethers that allow the mass to oscillate at a constant frequency in two orthogonal directions. When angular rotation is experienced, a detectable force proportional to the angular rate of rotation is generated in one of the orthogonal directions. However, such oscillating gyroscopes are limited in that they cannot typically achieve the high mass velocities that rotational masses can achieve. As a result, the precision of these oscillating MEMS gyroscopes has been limited.

## Summary of the Invention

The present inventors have invented a liquid bearing that substantially resolves the above problems with prior bearings. Specifically, bearings in accordance with the principles of the present invention use a droplet of liquid to separate a first surface having a plurality of nanostructures from a second surface which may or may not be nanostructured. In one embodiment, the liquid droplet is in contact with the nanostructures on the first surface and the second surface in a way such that friction is reduced between the first and second surfaces as one or both surfaces move laterally or rotationally. In another illustrative embodiment, the first surface of the bearing is a surface of a housing in a gyroscope and the second surface is a nanostructured surface of a mass adapted to rotate within the housing. Thus situated, the rotating mass moves with very low friction permitting, for example, the manufacture of very small high angular velocity, highly precise gyroscopes.

In another illustrative embodiment, the capacitance between at least a first segment on the gyroscope mass and at least a first segment on a surface of the housing is measured. The capacitance between the segments on the mass and the segments on the surface changes as a function of the distance between the segments. Therefore, by detecting relative or absolute changes in capacitance, the movement of the gyroscope housing is determined.

## Brief Description of the Drawing

FIGs. 1A, 1B, 1C, 1D and 1E show various prior art nanostructure feature patterns of predefined nanostructures that are suitable for use in the present invention;

FIG 2 shows an illustrative prior art device wherein a liquid droplet is disposed on a nanostructured feature pattern

FIG. 3A shows a prior art microline surface;

FIG. 3B shows a prior art micropost surface;

FIG. 3C shows a prior art nanopost surface;

FIG. 3D shows a droplet of liquid disposed on the prior art surface of FIG. 3A and the corresponding contact angle that results between the droplet and that surface;

FIG. 3E shows a droplet of liquid disposed on the prior art surface of FIG. 3B and the corresponding contact angle that results between the droplet and that surface;

FIG. 3F shows a droplet of liquid disposed on the prior art surface of FIG. 3C and the corresponding contact angle that results between the droplet and that surface;

FIG. 4 shows an illustrative embodiment of a bearing in accordance with the principles of the present invention;

FIG. 5 shows an illustrative embodiment of a gyroscope having a bearing in accordance with the principles of the present invention;

FIG. 6 shows an illustrative embodiment of how a droplet of liquid in a bearing can be made to move to and/or maintain a desired position on a surface in accordance with the principles of the present invention; and

FIG. 7 shows one illustrative embodiment wherein movement of the housing of the gyroscope of FIG. 5 is capable of being detected

## Detailed Description

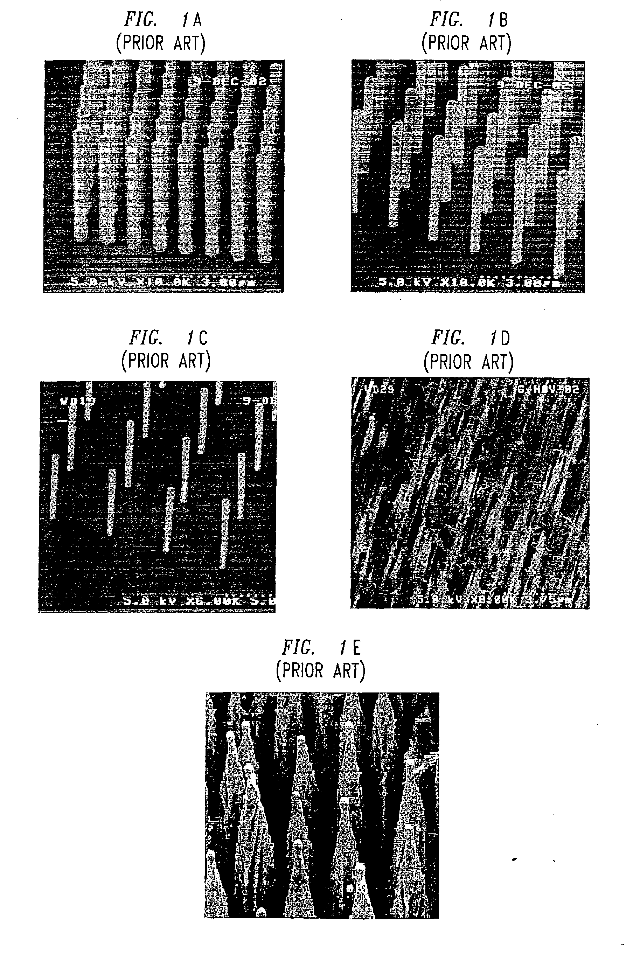

FIGs. 1A-1 E show different illustrative superhydrophobic surfaces produced using various methods. Specifically, these figures show surfaces having small posts, known as nanoposts and/or microposts with various diameters and with different degrees of regularity. An illustrative method of producing nanoposts and microposts, found in U.S. Patent No. 6,185,961, titled "Nanopost arrays and process for making same," issued February 13, 2001 to Tonucci, et al, is hereby incorporated by reference herein in its entirety. Nanoposts have been manufactured by various methods, such as by using a template to form the posts, by various means of lithography, and by various methods of etching.

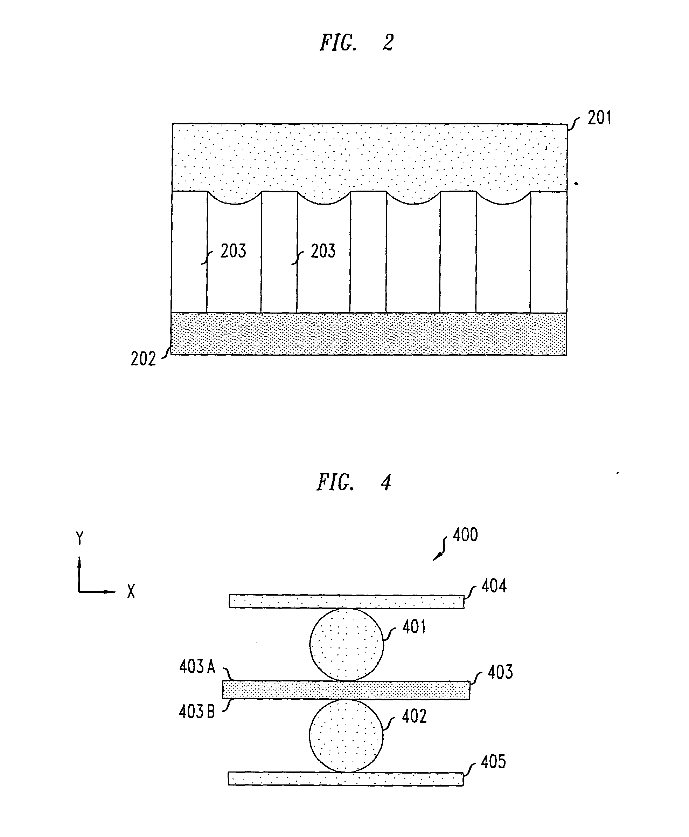

When a droplet of liquid, such as water, is placed on a surface having an appropriately designed nanostructured or microstructured feature pattern, the flow resistance experienced by the droplet is dramatically reduced as compared to a droplet on a surface having no such nanostructures or microstructures. Surfaces having such appropriately designed feature patterns are the subject of the article titled "Nanostructured Surfaces for Dramatic Reduction of Flow Resistance in Droplet-based Microfluidics", J. Kim and C.J. Kim, IEEE Conf. MEMS, Las Vegas, NV, Jan. 2002, pp. 479-482, which is hereby incorporated by reference herein in its entirety. That reference generally describes how, by using surfaces with predetermined nanostructure features, the flow resistance to the liquid in contact with the surface can be greatly reduced. Specifically, the Kim reference teaches that, by finely patterning the surface in contact with the liquid, and using the aforementioned principle of liquid surface tension, a droplet of liquid disposed on the surface will be supported on the tops of the nanostructure pattern, as shown in FIG. 2. Referring to FIG. 2, droplet 201 of an appropriate liquid (depending upon the surface structure) will enable the droplet 201 to be suspended on the tops of the nanoposts 203 with no contact between the droplet and the underlying solid surface. This results in an extremely low area of contact between the droplet and the surface 202 (i.e., the droplet only is in contact with the top of each post 203) and, hence a low flow resistance.

As typically defined a "nanostructure" is a predefined structure having at least one dimension of less than one micrometer and a "microstructure" is a predefined structure having at least one dimension of less than one millimeter. However, although the disclosed embodiments refer to nanostructures and nanostructured surfaces, it is intended by the present inventors, and will be clear to those skilled in the art, that microstructures may be substituted in many cases. Accordingly, the present inventors hereby define nanostructures to include both structures that have at least one dimension of less than one micrometer as well as those structures having at least one dimension less than one millimeter. The term "feature pattern" refers to either a pattern of microstructures or a pattern of nanostructures. Further, the terms "liquid," "droplet," and "liquid droplet" are used herein interchangeably. Each of those terms refers to a liquid or a portion of liquid, whether in droplet form or not.

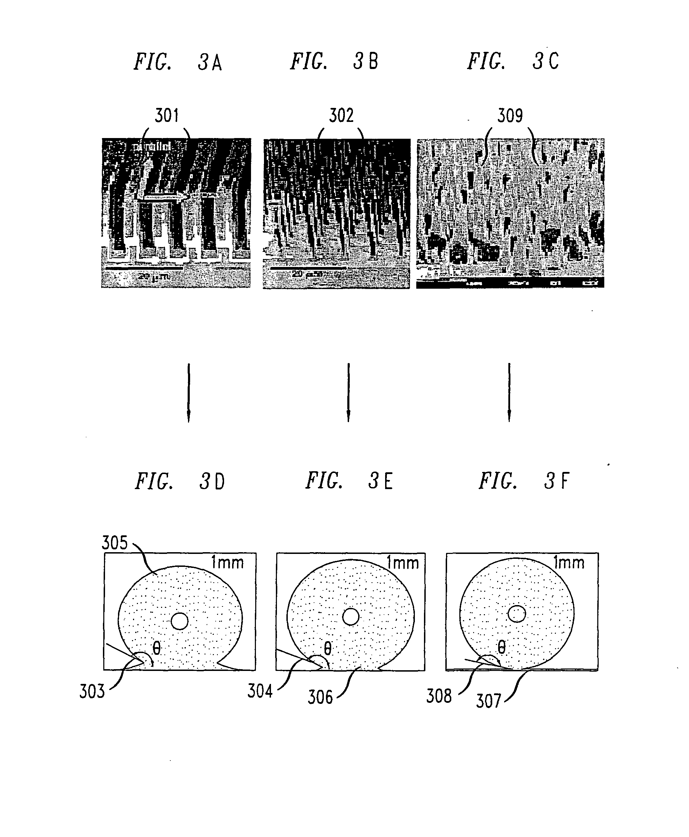

FIGs 3A-3F show how different, extremely fine-featured microstructure and nanostructure surface patterns result in different contact angles between the resulting surface and a droplet of liquid. Generally, the greater the contact angle, as shown in FIGs. 3A-3F, the lower the flow resistance experienced by the droplet. FIGs. 3A and 3B show a microline surface and a micropost surface, respectively. Each of the lines 301 in FIG. 3A is approximately 3-5 micrometers in width and each of the microposts 302 in FIG. 3B is approximately 3-5 micrometers in diameter at its widest point. Comparing the microline pattern to the micropost pattern, for a given size droplet disposed on each of the surfaces, the contact area of the droplet with the microline pattern will be greater than the contact area of the droplet with the micropost pattern. FIGs. 3D and 3E show the contact angle of a droplet relative to the microline surface of FIG. 3A and the micropost surface of FIG. 3B, respectively. The contact angle 303 of the droplet 305 on the microline pattern is smaller (~150 degrees) than the contact angle 304 of the droplet 306 with the micropost pattern (~160 degrees). As described above, it directly follows that the flow resistance exerted on the droplet by the microline pattern will be higher than that exerted by the micropost pattern.

FIG. 3C shows an even finer pattern than that of the microline and micropost pattern. Specifically, FIG. 3C shows a nanopost pattern with each nanopost 309 having a diameter of less than 1 micrometer. While FIG. 3C shows nanoposts 309 formed in a somewhat conical shape, other shapes and sizes are also achievable. In fact, cylindrical nanopost arrays have been produced with each nanopost having a diameter of less than 10 nm. Specifically, Referring to FIG. 3F, a droplet 307 disposed on the nanopost surface of FIG. 3C, is nearly spherical with a contact angle 308 between the surface and the droplet equal to between 175 degrees and 180 degrees. The droplet 307 disposed on this surface experiences nearly zero flow resistance.

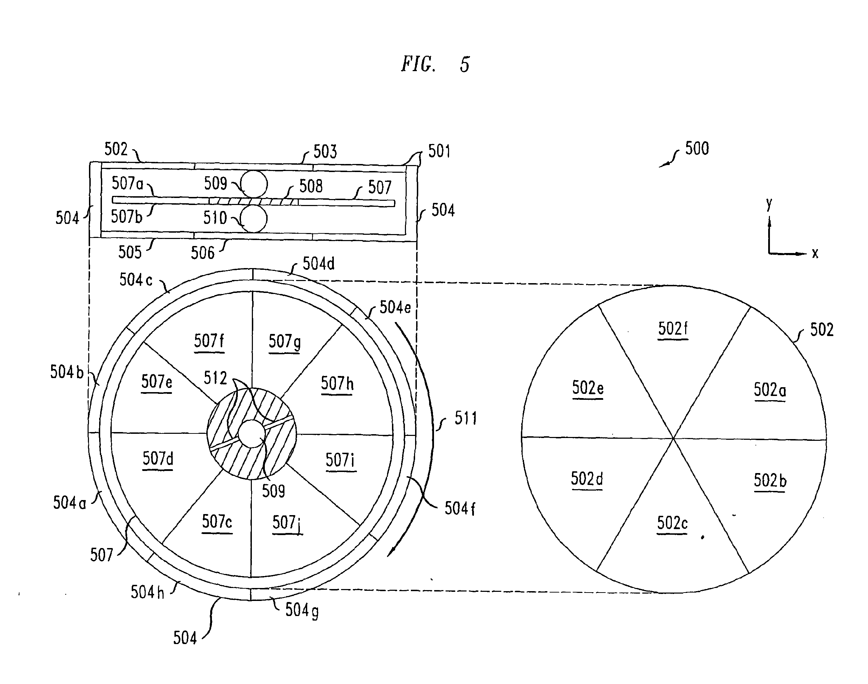

FIG. 4 shows one illustrative embodiment of a bearing 400 in accordance with the principles of the present invention. Specifically, FIG. 4 shows bearing 400 having a first surface 404 and a second surface 405. Surfaces 404 and 405 are, illustratively, surfaces of a housing. Component 403 is, for example, suspended between surfaces 404 and 405 by two illustrative droplets of liquid 401 and 402, respectively, which are, for example, droplets of water in contact with surfaces 403a and 403b of component 403. Surfaces 403a and 403b are illustratively nanostructured surfaces having, for example, a plurality of nanostructures or microstructures disposed thereon in order to reduce the flow resistance of that portion of the droplet in contact with component 403. Accordingly, as described above, one skilled in the art will recognize that component 403 can move laterally in direction x or rotationally about axis y, for example, and for the reasons described above, will experience an extremely low level of friction even at very small component sizes. Thus, droplets 401 and 402 function as a bearing in that they support component 403 between illustrative housing surfaces 404 and 405 while, at the same time, reducing friction that would otherwise occur between the housing and component 403.

The above-described friction reduction can be advantageous in many applications. For example, FIG. 5 shows an illustrative gyroscope device 500 in accordance with the principles of the present invention having a bearing similar to bearing 400 in FIG. 4. Specifically, referring to FIG. 5, gyroscope 500 has an illustrative cylindrical housing 501 with upper surface 502, lower surface 505 and side surface 504. Mass 507, illustratively an electrically conducting or partially electrically conducting disk having upper surface 507a and lower surface 507b, is separated from both upper surface 502 and lower surface 505 by droplets of liquid 509 and 510, respectively, which are illustrative electrically conducting droplets of water. Mass 507 is, illustratively, a disk having a diameter of between 10 and 1000 micrometers, however one skilled in the art will readily appreciate that the principles disclosed herein area equally applicable to a wide range of mass dimensions, both larger and smaller than the above range of diameters. One skilled in the art will also recognize in light of the teachings herein that many liquids may be advantageously used for droplets 509 and 510.

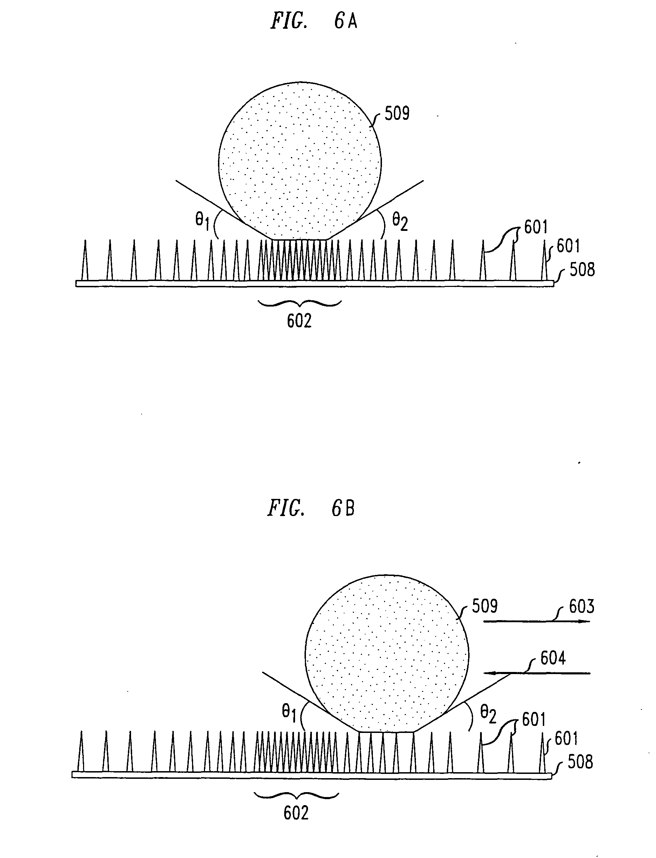

Droplets 509 and 510 illustratively contact mass 507 at area 508 which has, for example, a plurality of nanostructures disposed on both surfaces 507a and 507b. Droplets 509 and 510 are held in position on both sides of mass 507 in area 508 by, for example, varying the density of the nanostructures on the surfaces 507a and 507b. FIGs. 6A and 6B shows one embodiment in accordance with the principles of the present invention for varying the density of the nanostructures, here conical nanoposts, to cause the droplet to remain held in a desired position. Causing a droplet of liquid to be held in a position of higher density of nanostructures, or moving a droplet to such a position, is in part the subject of copending U.S. Patent Application, Serial Number 10/403159, filed 03/31/2003, and titled "Method and Apparatus for Controlling the Movement of a Liquid on a Nanostructured or Microstructured Surface," which is hereby incorporated by reference herein in its entirety.

Referring to FIG. 6A, nanostructures 601 on surface 507a in area 508 are arranged such that the droplet 509 maintains its position relative to area 508 on surface 507a. Specifically, the nanoposts 601 are arranged so that the density of nanoposts 601 is higher in area 508 at the center 602 of the plurality of nanoposts than it is at the outer edges of area 508. Thus, in its nominal position in area of nanoposts in the center 602 of nanoposts 601, the edges 605 and 606 of droplet 509 have angles of contact $\theta_1 = \theta_2$. However, referring to FIG. 6B, if the droplet 509 were to be displaced, for example, in direction 603, the edge 605 of droplet 509 would be in contact with a higher density of nanoposts than would edge 606. This increased density will lead to a lower contact angle at edge 605 of the droplet 509 relative to the contact angle at the edge 606 of the droplet 509. The lower contact angle at edge 605 leads to a lower force in direction 603 applied to the droplet 509 compared to the force generated in direction 604 by the relatively higher contact angle at edge 606. Thus, the droplet 509 will "drift" in direction 604 toward the area of higher density of nanoposts 602 as the liquid droplet 509 attempts to achieve equilibrium. Thus, by placing the highest density of nanoposts at that location at which it is desired to have the liquid droplet 509 positioned on the surface 507a, a liquid droplet can be displaced away from that position and it will autonomously move toward that area of highest density. One skilled in the art will recognize that there are other equally advantageous methods of holding causing droplet 509 to be held in a desired position other than that embodiment represented by FIG. 6. For example, as also discussed in the above referenced '159 US Patent Application, a voltage may be applied to that portion of the nanostructures to which the droplet is desired to be located. If the droplet is displaced away from that area, the voltage will result in a similar change in contact angle as that discussed above and, as a result, the droplet will once again drift back to its desired nominal position. The teachings of the present invention are intended to encompass all such methods of returning the droplet to a desired position on a nanostructured surface.

Referring once again to FIG. 5, droplets 509 and 510 are thus maintained in a desired position which is, illustratively, the position along the rotational axis of mass 507. In operations, mass 507 is caused to rotate in a way such that when the orientation of housing 501 changes, , the mass 507 tends to retain its orientation along the x-axis. In order to achieve the necessary rotation, the side surface 504 of housing 501 may act, illustratively, as part of an electrostatic drive system. Specifically, in order to achieve such a drive system, mass 507 is segmented into a plurality of illustrative electrically conductive disk segments 507c - 507j and side surface 504 is similarly segmented into a plurality of electrically conductive housing segments 504a - 504h. Although the number of segments of the mass is, as illustrated in FIG. 5, the same as the number of segments of the housing, one skilled in the art will recognize in light of the teachings herein, that many configurations of segments of either the housing and/or the disk are possible to achieve equally advantageous results. In order to initiate and maintain rotation of the mass 507, a charge is illustratively applied to opposing segments of the mass such as, in this illustrative example, a positive charge applied to segments 507d and segments 507h. Such a positive charge may be applied, for example, by passing an electrical current from a current source to segments 507d and 507h via droplet 509 and electrical leads 512. In this example, rotation of the mass is initiated by applying an illustrative negative charge to a plurality of housing segments, such as, for example, segments 504b and 504f. When such a negative charge is applied, the positively charged mass segments will be attracted to the closest housing segment having a negative charge thus causing, in this example, the disk to begin rotating in direction 511. If the negative charge was maintained on housing segments 504b and 504f, the disk would eventually reach equilibrium with mass segment 507d centered on housing segment 504b and disk segment 507h centered on housing segment 504f. Accordingly, in order to achieve a desired rotational velocity of mass 507, the negative charge applied to the housing segments is advanced progressively faster from one housing segment to the next on opposite sides of the housing. For example, once the mass 507 begins rotating, the charge applied to housing segments 504b and 504f will be removed, replaced with a negative charge to housing segments 504c and 504g, respectively. This is then followed by sequentially applying a negative charge to each segment in the housing at a faster and faster rate of progression until the desired rotational velocity of mass 507 is achieved.

In order to maintain the rotational velocity of the mass, the sequential progression of applied negative charges to the housing segments can be maintained at a desired progression frequency. One skilled in the art will recognize in light of the teachings herein that, for previously discussed reasons, friction between the interface of the nanostructured surfaces of mass 507 and the droplets 509 and 510, is significantly reduced or eliminated. Thus, in one illustrative embodiment, the velocity of the mass 507 is, illustratively, 600,000 rotations per minute. Such a high velocity is made possible by the low friction interface resulting from the liquid bearings described herein. As discussed previously, such high angular velocities will lead to relatively high angular momentum, as calculated by Equation 1, even though the size and mass of the rotating disk is so small. Thus, even when the disk experiences an external torque, the principle of angular momentum will be retained, thus permitting the device to operate as a highly precise gyroscope. One skilled in the art will realize that many configurations may be used to initiate and maintain the rotation of disk 507 such as, for example, applying an electrical charge to any number of one or more of the disk segments and/or the housing segments. All methods initiating rotation of the mass 507 within housing 501 are intended to be encompassed by the teachings of the present invention.

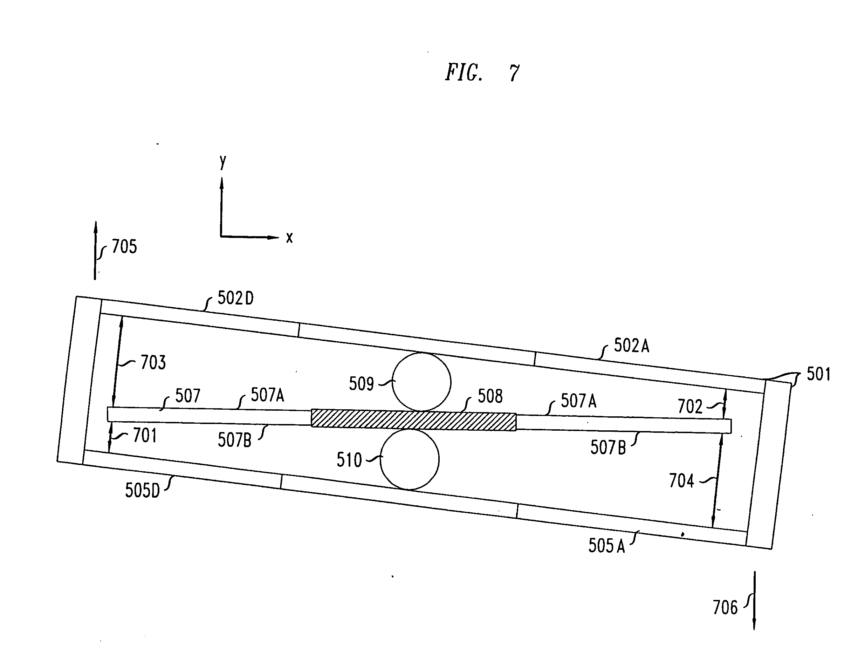

Gyroscopes, such as gyroscope 500 in FIG. 5, are useful for detecting when the platform upon which the gyroscope is mounted moves from a nominal position. FIG. 7 shows how such a movement of housing 501 is detected when that housing is displaced from its nominal position. Specifically when, for example, housing 501 is displaced in directions 705 and 706 (e.g., the housing is rotated), mass 507 will tend to stay oriented in its nominal position of rotation along about the y-axis. Thus, one illustrative method of detecting when the orientation of housing 501 has changed is to detect when distances 701, 703, 702 and/or 704, which represent the distance between the outer edges of the mass 507 and portions of surfaces 502 and 505, change. Referring once again to FIG. 5, one method of detecting such a change is to segment surface 502 and surface 505 into a plurality of, for example, electrically conducting segments 502a - 502f. Although not shown in FIG. 5, surface 505 is illustratively divided into segments 505a - 505f that correspond to segments 502a - 502f of surface 502 such that, when viewed from above, segment 505a would lie directly below segment 502a, segment 505b would lie directly below segment 502b, etc. One skilled in the art will recognize that, while six segments are shown in the illustrative embodiment of FIG. 5, any suitable number of segments could be used equally advantageously.

Referring once again to FIG. 7, when housing 501 rotates in directions 706 and 705, as discussed above, surfaces 507a and 507b of mass 507 change distance relative to, for example, illustrative segments 502d, 505d, 502a and 505a of surfaces 502 and 505, respectively, in FIG. 5. As previously discussed, some or all of the segments of both the housing surface 502 and the mass 507a may be manufactured from an electrically conducting material. If so, when a current is passed over at least some of the segments of disk 507 (such as the aforementioned segments 507d and 507h shown in FIG. 5), a measurable capacitance is created between the segments on surface 507a and each of the segments on surface 502, such as segments 502a and 502d in FIG. 7. Similarly, a measurable capacitance is created between the segments on surface 507b and each of the segments on surface 505, such as segments 505a and 505d in FIG. 7. As the segments on mass 507 become closer or further from the segments of surfaces 502 and 505, these measurable capacitances change. Specifically, in the illustrative embodiment shown in FIG. 7, as the housing 501 rotates, surface 507a becomes positioned further away from segment 502d and closer to segment 502a while surface 507b becomes positioned closer to segment 505d and further from segment 505a. Accordingly, for example, the capacitance as measured from segment 502d drops and the capacitance as measured from segment 502a rises. One skilled in the art will recognize that, if capacitance measurements are taken in all segments on, for example, surface 502, a relatively high degree of precision of detection of the motion of housing 501 can be achieved.

The foregoing merely illustrates the principles of the invention. It will thus be appreciated that those skilled in the art will be able to devise various arrangements which, although not explicitly described or shown herein, embody the principles of the invention and are within its spirit and scope. For example, one skilled in the art, in light of the descriptions of the various embodiments herein, will recognize that the principles of the present invention may be utilized in widely disparate fields and applications. For example, while a gyroscope is presented herein as an illustrative embodiment of how the liquid bearings of the present invention may be used, one skilled in the art will fully appreciate the wide-ranging potential use of such bearings in many applications. For example, one skilled in the art will recognize that the illustrative gyroscope using the novel bearings described herein above can also be characterized as a MEMS motor. Previous MEMS motors have been used in such applications as microfluidics pumps or microchemical reactors. However, these devices were typically characterized as having moving mechanical parts in direct contact with one another. Thus, such motors were relatively unreliable as, eventually, one or more parts of the motor would deteriorate to the point that the motor would not operate. Since the illustrative liquid bearings described herein have no mechanical part-to-mechanical part contact, the reliability of MEMS motors relying on these bearings could be potentially dramatically improved.

Additionally, MEMS motors using bearings in accordance with the principles of the present invention could be advantageously used in optical application such as, for example, in an optical switch. Such switches frequently rely on small mirrors that are reoriented, typically, by using electrostatic force to move mirrors mounted on, for example, torsion springs. However, generating such electrostatic forces typically required complicated algorithms and control logic to accomplish precise movements of each mirror in, for example, an array of mirrors. A liquid bearing- based MEMS motor that is capable of moving in steps (i.e., a stepping motor) could be used as a highly reliable, simplified mechanism to reliably and quickly achieve new mirror orientations. Such motors would overcome the inherent limitations of prior electrostatic mirror systems.

One skilled in the art will be able to devise many similar uses of the underlying principles associated with the present invention, all of which are intended to be encompassed herein. All examples and conditional language recited herein are intended expressly to be only for pedagogical purposes to aid the reader in understanding the principles of the invention and are to be construed as being without limitation to such specifically recited examples and conditions. Moreover, all statements herein reciting aspects and embodiments of the invention, as well as specific examples thereof, are intended to encompass functional equivalents thereof.

**Claims**

1. A liquid bearing comprising:

   a first surface;
   a plurality of nanostructures disposed on at least a first area of said first surface;
   a second surface;

a liquid droplet in contact with said plurality of nanostructures on said first surface and said second surface, said droplet adapted to reduce friction between said at least a first nanostructured surface.

2. The liquid bearing of claim 1 wherein said first surface is the surface of a component adapted to move laterally with respect to said second surface.

3. The liquid bearing of claim 1 wherein said first surface is the surface of a component adapted to move rotationally with respect to said second surface.

4. The liquid bearing of claim 1 wherein said liquid droplet is disposed in a way such that it is suspended substantially on the ends of the nanostructures in said plurality of nanostructures.

5. The liquid bearing of claim 1 wherein said second surface comprises a plurality of nanostructures.

6. The liquid bearing of claim 1 wherein the density of a first portion of nanostructures in said plurality of nanostructures is different from the density of a second portion of said nanostructures in said plurality of nanostructures in a way such that said liquid droplet maintains a desired position relative to said first portion of nanostructures.

7. The liquid bearing of claim 1 wherein said first surface and said second surface are surfaces of a microelectromechanical system motor.

8. The liquid bearing of claim 1 wherein said first surface and said second surface are surfaces of a microfluidic pump.

9. A gyroscope comprising:

a housing;
a mass comprising a first nanostructured surface and a second nanostructured surface;
a first droplet of liquid disposed in a way such that said mass is separated by said liquid from a first surface of said housing;
a second droplet of liquid disposed in a way such that said mass is separated by said second liquid from a second surface of said housing;
means for initiating and maintaining at least a first nonzero angular velocity of said mass;
means for detecting whether said mass has changed position relative to at least a third surface of said housing.

10. A method for reducing friction between a first surface and a second surface, said first surface comprising a plurality of nanostructures, said first surface adapted to move laterally relative to said second surface, said method comprising:

disposing at least a first droplet of liquid in a way such that said droplet is in contact with at least a portion of nanostructures in said plurality of nanostructures,

wherein said at least a first droplet of liquid is also in contact with said second surface in a way such that said second surface is separated from said at least a portion of nanostructures by said at least a first droplet.

*FIG.* 1 A
(PRIOR ART)

*FIG.* 1 B
(PRIOR ART)

*FIG.* 1 C
(PRIOR ART)

*FIG.* 1 D
(PRIOR ART)

*FIG.* 1 E
(PRIOR ART)

FIG. 2

201

203    203

202

FIG. 4

Y

X

400

404

401

403A

403

403B

402

405

*FIG.*    *3* A        *FIG.*    *3* B        *FIG.*    *3* C

301           302           309

*FIG.*    *3* D        *FIG.*    *3* E        *FIG.*    *3* F

305          1mm        1mm        1mm

$\theta$          $\theta$          $\theta$

303        304    306        308   307

*FIG. 5*

EP 1 580 528 A1

FIG. 6A

FIG. 6B

FIG. 7

**European Patent Office**

**EUROPEAN SEARCH REPORT**

Application Number

EP 05 25 1555

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DE 102 27 458 A1 (FAUNER, GERHARD; WENDKER, HASSO) 22 January 2004 (2004-01-22) | 1-3,5,10 | G01C19/16 F16C33/10 B81B5/00 |
| A | * paragraph [0011] - paragraph [0026]; figures 1,2 * ----- | 4 | |
| A | DE 101 01 229 A1 (DORMA GMBH + CO. KG) 25 July 2002 (2002-07-25) * paragraph [0022] - paragraph [0028]; claim 1; figures 1-4 * ----- | 1,2,4,5, 10 | |
| A | DE 100 09 142 A1 (FAUNER, GERHARD; WENDKER, HASSO) 6 September 2001 (2001-09-06) * column 2, line 58 - column 3, line 10; claims 1,2,6,17,18,26; figures 1-5 * ----- | 1-5,10 | |
| A | EP 1 335 187 A (SAMSUNG ELECTRONICS CO., LTD) 13 August 2003 (2003-08-13) * the whole document * ----- | 9 | TECHNICAL FIELDS SEARCHED (Int.Cl.7) G01C F16C B81B |

The present search report has been drawn up for all claims

| Place of search | Date of completion of the search | Examiner |
|---|---|---|
| Munich | 8 July 2005 | Fischbach, G |

EPO FORM 1503 03.82 (P04C01)

## ANNEX TO THE EUROPEAN SEARCH REPORT
## ON EUROPEAN PATENT APPLICATION NO.

EP 05 25 1555

This annex lists the patent family members relating to the patent documents cited in the above-mentioned European search report.
The members are as contained in the European Patent Office EDP file on
The European Patent Office is in no way liable for these particulars which are merely given for the purpose of information.

08-07-2005

| Patent document cited in search report | | Publication date | Patent family member(s) | | Publication date |
|---|---|---|---|---|---|
| DE 10227458 | A1 | 22-01-2004 | NONE | | |
| DE 10101229 | A1 | 25-07-2002 | NONE | | |
| DE 10009142 | A1 | 06-09-2001 | NONE | | |
| EP 1335187 | A | 13-08-2003 | KR | 2003067791 A | 19-08-2003 |
| | | | EP | 1335187 A1 | 13-08-2003 |
| | | | JP | 2003247831 A | 05-09-2003 |
| | | | US | 2003164041 A1 | 04-09-2003 |

For more details about this annex : see Official Journal of the European Patent Office, No. 12/82